# EUROPÄISCHE PATENTSCHRIFT

(11) **EP 3 429 906 B1**
(45) Veröffentlichungstag und Bekanntmachung des Hinweises auf die Patenterteilung: **13.05.2020**
(21) Anmeldenummer: 17704449.2
(22) Anmeldetag: 08.02.2017
(51) Int. Cl.: B62D 1/04, B62D 1/28, B60W 50/08

(54) **VERFAHREN UND VORRICHTUNG ZUR DEAKTIVIERUNG EINES FAHRERASSISTENZSYSTEMS**
METHOD AND DEVICE FOR DEACTIVATING A DRIVER ASSISTANCE SYSTEM
PROCÉDÉ ET DISPOSITIF DE DÉSACTIVATION D'UN SYSTÈME D'AIDE À LA CONDUITE

(30) Priorität: 16.03.2016 DE 102016204343
(43) Veröffentlichungstag der Anmeldung: 23.01.2019
(73) Patentinhaber: Bayerische Motoren Werke Aktiengesellschaft, 80809 München (DE)
(72) Erfinder: HERGETH, Sebastian, 80637 München (DE)
(86) Internationale Anmeldenummer: PCT/EP2017/052772
(87) Internationale Veröffentlichungsnummer: WO 2017/157588

(56) Entgegenhaltungen:
- DE-A1-102013 010 928
- US-A1- 2014 365 076

## Beschreibung

Die Erfindung betrifft ein Verfahren und eine Vorrichtung zur Deaktivierung eines Fahrerassistenzsystems zur autonomen Querführung eines Fahrzeuges nach dem Oberbegriff des Anspruchs 1. Zum Stand der Technik wird beispielshalber auf die DE 10 2006 023 287 A1 und insbesondere auf die DE 2015 101 563 A1 verwiesen. DE 10 2013 010928 A1 ist als nächstliegender Stand der Technik nach dem Oberbegriff des Anspruchs 1 zu sehen.

Aus dem Stand der Technik sind viele Konzepte des hochautomatisierten Fahrens und der dafür zuständigen Fahrerassistenzsysteme bekannt. So sind beispielsweise Fahrerassistenzsysteme bekannt, die den Fahrer bei der Fahraufgabe unterstützen oder sogar solche, die es veranlassen, dass das Fahrzeug bestimme Fahraufgaben wie beispielsweise die Längsführung und/oder die Querführung eines Fahrzeuges komplett übernehmen. Dabei wird der Fahrer in sicherheitskritischen Situationen, in welchen die Assistenzfunktion der Fahrerassistenzsysteme nicht mehr ausreicht, vom Fahrerassistenzsystem dazu aufgefordert, die Fahrzeugführung selbst zu übernehmen. Diese Aufforderung wird als sogenannte Übernahmeaufforderung bezeichnet. Außerdem bleibt der Fahrer ständig in der Lage, auf Wunsch in die hochautomatisierte Aufgabe des Fahrerassistenzsystems einzugreifen und die Fahraufgabe damit manuellen zu übernehmen. Je nach Fahraufgabe, welche das Fahrerassistenzsystem übernimmt, existieren unterschiedliche Übernahmekonzepte, also Wege bzw. Handlungen, die der Fahrer ausübt, um zu signalisieren, dass er die jeweilige Fahraufgabe selbst übernehmen möchte und damit das Fahrerassistenzsystem, welches die hochautomatisierte Fahraufgabe zu dem Zeitpunkt ausführt, zu deaktivieren. So ist es beispielsweise bekannt, ein ACC-System (Automatic Cruise Control), welches die Längsführung des Fahrzeuges auf Autobahnen übernimmt, durch das Betätigen eines Gas- oder Bremspedals durch den Fahrer zu deaktivieren. Bei hochautomatisierter Querführung sind Übernahmekonzepte durch Eingriffe in das Lenkrad, also eine Betätigung des Lenkrades durch den Fahrer bekannt. So ist beispielsweise aus der DE 10 2015 101 563 A1 ein System zum automatisierten Fahren bekannt, welches durch eine Berührung und gleichzeitiges Drehen des Lenkrads durch den Fahrer deaktiviert wird. Zur Erkennung ob der Fahrer das Lenkrad berührt und das Lenkrad dreht, sind kapazitive Sensoren und Drehmomentensensoren im Lenkrad angebracht. Um mit einer hohen Wahrscheinlichkeit sicherzustellen, dass ein Fahrerwunsch zur Übernahme der Assistenzfunktion vorliegt, werden hierbei beide Sensorsignale benötigt um das Fahrerassistenzsystem auszuschalten. Der Fahrer muss also sowohl das Lenkrad berühren, als auch drehen.
Sensoriken zur Erkennung, ob sich die Hände des Fahrers am Lenkrad befinden und wie stark dieser das Lenkrad umfasst sind aus anderen Bereichen der Fahrerassistenz bekannt. So geht aus der DE 10 2006 023 287 A1 ein Greifkraftsensor für ein Lenkrad hervor, welcher als ein piezoelektrischer Drucksensor ausgeführt ist und durch welchen ein physischer Belastungszustand des Fahrers, wie beispielsweise Ermüdung oder Stressbelastung festgestellt werden kann.
Beim hochautomatisierten Fahren, insbesondere bei einer autonomen Querführung, sind die Übernahmekonzepte üblicherweise mit einem Eingriff in die Lenkung durch den Fahrer, also mit einer Betätigung des Lenkrades verbunden.

Negativ an den derzeitigen aus dem Stand der Technik bekannten Übernahmekonzepten einer autonomen Querführung eines Fahrerassistenzsystems ist es, dass eine Übernahme von der autonomen Querführung in die manuelle Querführung durch den Fahrer unwillkürlich, durch leichte Berührung oder unbeabsichtigte Verdrehung des Lenkrades, beispielsweise durch das Anlehnen des Knies des Fahrers am Lenkrad, ausgelöst werden kann. Der Fahrer ist in derartigen Situationen nicht auf eine Übernahme der Querführung vorbereitet und deswegen auch nicht sofort in der Lage, die Querführung des Fahrzeugs zu übernehmen. In ungünstigen Situationen kann es so durch die Unaufmerksamkeit des Fahrers zu Fehlern führen.

Aufgabe der vorliegenden Erfindung ist es deswegen, eine Deaktivierung bzw. ein Übernahmekonzept eines Fahrerassistenzsystems zur autonomen Querführung eines Fahrzeuges bereitzustellen, welches unwillkürliche bzw. versehentliche Signale eines Übernahmewunsches vom Fahrer, beispielsweise durch eine Abstützung des Knies am Lenkrad, nur schwer zulässt und gleichzeitig ein technisch einfach realisierbares Konzept darstellt.

Die Lösung der Aufgabe ergibt sich mit den Merkmalen des Anspruchs 1. Vorteilhafte Aus- und Weiterbildungen sind Inhalt der Unteransprüche.

Dabei wird ein Verfahren bzw. eine Vorrichtung zur Deaktivierung eines Fahrerassistenzsystems zur autonomen Querführung eines Fahrzeuges vorgeschlagen, welches eine Berührung des Lenkradkranzes durch den Fahrer mittels eines erfindungsgemäßen Drucksensors erfasst, einen Übernahmewunsch des Fahrers erkennt und das Fahrerassistenzsystem ausschaltet.
Erfindungsgemäß erstreckt sich der genannte Drucksensor zumindest über einen Teil derjenigen Oberfläche des Lenkradkranzes, welche der Fahrer üblicherweise mit seinen Händen berührt. Um jedoch unbeabsichtigte Berührungen, welche häufig durch das Anstoßen bzw. Anlehnen der Knie oder der Beine des Fahrers entstehen zu vermeiden, wird derjenige Bereich der Oberfläche des Lenkradkranzes, welcher in einem Querschnitt des Lenkradkranzes betrachtet einen sich über einen Sektorwinkel in der Größenordnung von 90° erstreckenden annährend kreissegmentförmigen Bogen beschreibt, der weitest möglich vom Lenkradmittelpunkt beabstandet ist, nicht von dem Drucksensor bedeckt bzw. nicht auf Berührung hin überwacht.
Je nach Breite bzw. je nach Durchmesser des Lenkradschlauchs, also der Grifffläche des Lenkradkranzes kann der genannte Sektorwinkel variieren. So wird ein Sektorwinkel bei einer breiteren Grifffläche von mehr als 90° und bei einer schmäleren Grifffläche von etwas weniger als 90 °gewählt.
Diese erfindungsgemäße Freilassung des mit der Drucksensorik überdeckten Lenkradkranzes, an den vom Lenkradmittelpunkt aus betrachtet äußeren Bereichen des Lenkrades, an welchem insbesondere die Beine bzw. die Knie des Fahrers bei einem Wechsel einer Sitzposition anstoßen oder anlehnen, verhindert einen unwillkürlichen Eingriff in die autonome Querführung und damit eine unwillkürliche Deaktivierung des Fahrerassistenzsystems. Damit können oben beschriebene sicherheitskritische Situationen, in denen der Fahrer nicht auf die Übernahme der Querführung des Fahrzeuges vorbereitet ist und seine Konzentration möglicherweise anderen Dingen als der Fahrzeugführung zuwendet, vermieden werden.

Die Ausgangssituation zur Einleitung des erfindungsgemäßen Verfahrens ist eine autonome Querführung des Fahrzeuges durch das Fahrerassistenzsystem. Der Fahrer berührt dabei das Lenkrad mit seinen Händen nicht. Beabsichtigt nun der Fahrer die Querführung des Fahrzeuges selbst zu übernehmen oder fordert das Fahrerassistenzsystem den Fahrer zu einer Übernahme auf, so greift der Fahrer mit seinen Händen an das Lenkrad. Die am Lenkrad angebrachte Drucksensorik erfasst dabei die Berührung des Lenkrads durch die Hände des Fahrers.

In einer vorteilhaften Ausführung ist eine Steuereinheit in diesem Zustand dazu veranlasst, aufgrund der Höhe des aufgewendeten Berührungsdrucks festzustellen, ob ein Übernahmewunsch bzw. ein Übernahmeversuch des Fahrers bei dieser Berührung vorliegt. Dazu kann je nach Fahrsituation ein Grenzwert des vom Fahrer initiierten Berührungsdrucks eingestellt werden und nur bei Überschreitung dieses Grenzwertes wird eine Deaktivierung der autonomen Querführung von der Steuereinheit veranlasst. An dieser Stelle bzw. bei Überschreitung des genannten Grenzwertes übernimmt der Fahrer die Querführungsaufgabe des Fahrzeugs.
Mit der Einführung des genannten Grenzwertes kann auf eine vorteilhafte Art und Weise vermieden werden, dass unbeabsichtigte Berührungen, welche mit nur einem sehr leichten Druck vom Fahrer ausgeübt werden, von der Steuereinheit als Übernahmewunsch des Fahrers interpretiert werden und das Fahrerassistenzsystem fälschlicherweise deaktiviert wird.

In einer vorteilhaften Ausführung der Erfindung kann der genannte Grenzwert des Berührungsdrucks des Fahrers, ab welchem eine Deaktivierung des Fahrerassistenzsystems zur autonomen Querführung stattfindet, fahrsituationsabhängig eingestellt bzw. verändert werden.
So kann der der Grenzwert geschwindigkeitsabhängig eingestellt werden und beispielsweise bei steigender Geschwindigkeit des Fahrzeuges erhöht werden. Denn bei hohen Geschwindigkeiten, beispielsweise während einer Autobahnfahrt, ist es von großer Bedeutung, dass bei Berührung des Lenkrads durch den Fahrer während einer autonomen Querführung des Fahrzeuges das Fahrerassistenzsystem nur dann deaktiviert wird, wenn der Fahrer eine Übernahme der Querführungsaufgabe beabsichtigt. Bei Erhöhung des Grenzwertes muss der Fahrer folglich etwas fester an das Lenkrad fassen. Damit wird sichergestellt, dass keine versehentliche bzw. unwillkürliche Berührung des Lenkrads durch den Fahrer stattfindet.
Des Weiteren ist es denkbar, den genannten Grenzwert anhand bestimmter Signale einzustellen bzw. zu verändern, wie beispielsweise bei einer vorliegenden Aufforderung des Fahrerassistenzsystems an den Fahrer zur Übernahme der Querführung des Fahrzeuges. So kann der Grenzwert bei vorliegender Übernahmeaufforderung, also wenn das Fahrerassistenzsystem bereits auf eine Reaktion des Fahrers bzw. auf eine Berührung des Lenkrades durch den Fahrer wartet, niedriger eingestellt werden. Das Signal zur Übernahmeaufforderung seitens des Fahrerassistenzsystems wird dann direkt an die Steuereinheit übermittelt, welche den Grenzwert des Berührungsdrucks dementsprechend erniedrigt und auf eine Berührung seitens des Fahrers wartet. Die Übernahme geschieht somit schneller und zuverlässiger.
In einer weiteren vorteilhaften Ausführung ist der genannte Grenzwert in Abhängigkeit von Umweltbedingungen, wie beispielsweise von Wetterbedingungen oder auch von Fahrbahngegebenheiten, wie beispielsweise bei unebenen, glatten oder nassen Fahrbahnen, einstellbar bzw. veränderbar.

Die Drucksensorik ist erfindungsgemäß derart auf dem Lenkradkranz positioniert, dass eine versehentliche Berührung des Lenkrades mit anderen Körperteilen abgesehen von den Händen, wie beispielsweise den Beinen oder den Knien, und damit eine versehentliche Deaktivierung des Fahrerassistenzsystems zur Querführung des Fahrzeuges vorteilhaft vermieden wird. Berührt also der Fahrer während der autonomen Querführung des Fahrzeuges versehentlich, beispielsweise mit seinem Knie, das Lenkrad an der beschriebenen vom Lenkradmittelpunkt betrachtet äußeren Oberfläche des Lenkradkranzes, an welcher sich keine Drucksensorik befindet, so werden folglich auch keine Signale an die Steuereinheit gesendet und das Fahrerassistenzsystem zur Querführung des Fahrzeuges nicht deaktiviert.

Der Drucksensor besteht dabei vorzugsweise aus einem Material, welches unter Einwirkung von Druck ein elektrisches Signal abgibt und einen sogenannten intelligenten Werkstoff bzw. intelligentes Material darstellt. Das intelligente Material erfüllt die sensorische Funktion, während die Umsetzung des sensorischen Signals externen Reglern und Energieversorgungen überlassen wird. Beispiele für ein derartiges Material sind piezoelektrische, magnetorheologische, elektrorheologische oder dielektrische Materialien. Vorteilhaft wird das intelligente Material unter der Lederhaut des Lenkradkranzes in Form einer Folie oder einer Membran flächendeckend angebracht. An welchen Stellen genau sich die Folie bzw. Membran über den Lenkradkranz erstreckt ist außer dem genannten ausgelassenen äußeren Bereich nicht eingeschränkt. So kann die Folie beispielsweise nur auf einer Ringfläche auf der zum Fahrer zugewandten Seite des Lenkradkranzes an diesem angebracht sein oder sich über die gesamte Lenkradkranzfläche (außer der erfindungsgemäßen freigelassenen Fläche) erstrecken.
Beispielsweise kann die Drucksensorik in Form einer Folie bzw. einer dünnen Membran aus einem piezoelektrischen Material ausgeführt und unter der Lederschicht des Lenkradkranzes angebracht sein. Durch die mechanische Deformation bzw. durch die elastische Verformung der Membran beim Berühren des Lenkradkranzes werden elektrische Signale erzeugt. Der Berührungsdruck kann somit auf technisch einfache Weise gemessen werden.
In einer weiteren vorteilhaften Ausführung wird ein dielektrisches Elastomer folienartig bzw. membranartig als Drucksensorik zur Messung des Berührungsdrucks verwendet. Bei der Verformung unter Aufwendung des Berührungsdrucks verringert sich die Dicke der Elastomerfolie, während sich die Fläche der Folie vergrößert. Dadurch entsteht eine elektrische Kapazitätserhöhung, anhand welcher der Druck gemessen werden kann.
Durch Veränderung der Drucksensibilität der Materialien kann dann auch der genannte Grenzwert des Berührungsdrucks fahrsituationsabhängig eingestellt werden.

Im Folgenden wird die Erfindung anhand eines Ausführungsbeispiels näher erläutert. Figur 1 zeigt dabei ein Fahrzeuglenkrad in einer Draufsicht, während Figur 2 ein Fahrzeuglenkrad in einer Seitenansicht zeigt. In Figur 3 wird die Erfindung anhand einer Querschnittansicht des Lenkradkranzes aufgezeigt.

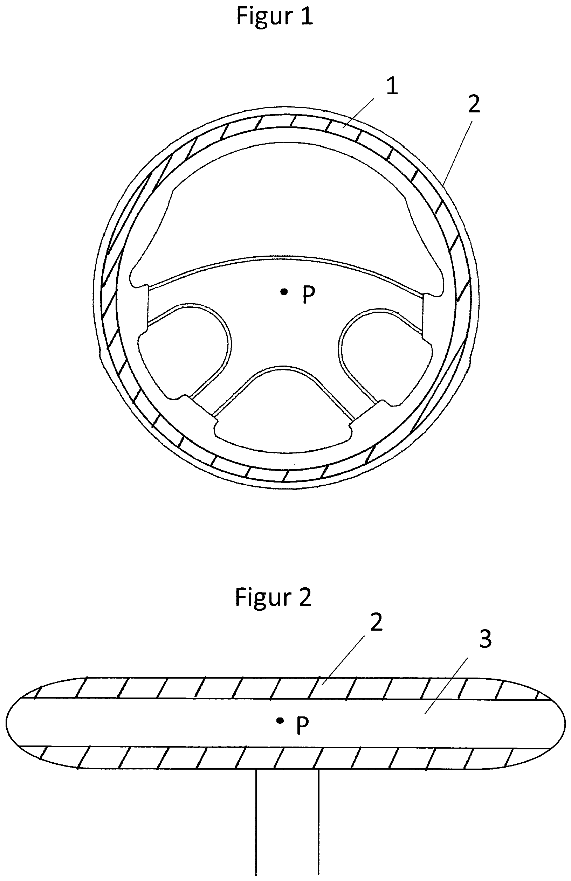

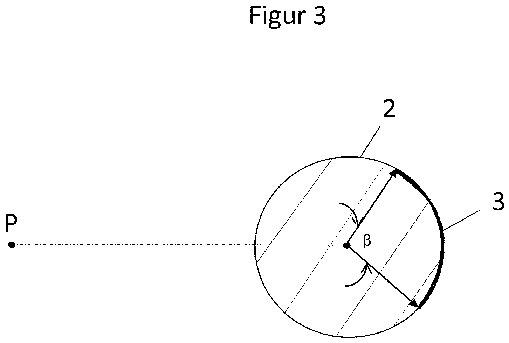

Figur 1 zeigt ein Fahrzeuglenkrad in einer Draufsicht, wobei sich die erfindungsgemäße Drucksensorik 1 in diesem konkreten Beispiel als eine ringförmige Folie bzw. Membran an einer dem Fahrer zugewandten Seite des Lenkradkranzes 2 befindet. In Figur 2 wird schematisch der Bereich 3 auf dem Lenkradkranz aufgezeigt, welcher nicht durch die Drucksensorik abgedeckt ist. In Figur 3 ist dabei in einem Querschnitt des Lenkrades aus Figur 2 der Bereich 3 der Oberfläche des Lenkradkranzes 2 aufgezeigt, welcher sich über einen Sektorwinkel β in der Größenordnung von 90° erstreckenden annährend kreissegmentförmigen Bogen beschreibt, der weitest möglich vom Lenkradmittelpunkt P beabstandet ist. Da der Bereich 3 häufig von anderen Körperteilen als den Händen, insbesondere von den Beinen oder den Knien des Fahrers berührt wird, wird dieser Bereich 3 nicht von der Drucksensorik 1 überdeckt. Dadurch kann eine unerwünschte Deaktivierung des Fahrerassistenzsystems zur autonomen Querführung vermieden werden.

## Patentansprüche

1. Verfahren zur Deaktivierung eines Fahrerassistenzsystems zur autonomen Querführung eines Fahrzeuges, welches eine Sensoreinheit zur Erfassung einer Berührung des Kranzes (2) eines Lenkrads durch den Fahrer umfasst, sowie eine Steuereinheit, welche mittels der erfassten Berührung einen Übernahmewunsch des Fahrers von der autonomen Querführung in eine manuelle Querführung durch den Fahrer erkennt,
**dadurch gekennzeichnet, dass**
die Sensoreinheit mindestens einen Drucksensor (1) darstellt, welcher sich zumindest über einen Teil derjenigen Oberfläche des Lenkradkranzes (2) erstreckt, welche der Fahrer üblicherweise mit seinen Händen berührt, jedoch denjenigen Bereich (3) der Oberfläche des Lenkradkranzes (2) nicht umfasst, welcher in einem Querschnitt des Lenkradkranzes (2) betrachtet einen sich über einen Sektorwinkel (β) in der Größenordnung von 90° erstreckenden annährend kreissegmentförmigen Bogen beschreibt, der weitest möglich vom Lenkradmittelpunkt (P) beabstandet ist.

2. Verfahren nach Anspruch 1, wobei die Steuereinheit die autonome Querführung nur bei Überschreitung eines Grenzwertes des vom Drucksensor (1) erfassten Berührungsdrucks deaktiviert.

3. Verfahren nach Anspruch 2, wobei der Grenzwert fahrsituationsabhängig einstellbar ist.

4. Verfahren nach Anspruch 3, wobei der Grenzwert mit steigender Fahrgeschwindigkeit höher eingestellt wird.

5. Verfahren nach einem der vorangegangen Ansprüche, wobei der Grenzwert bei Eintritt einer Übernahmeaufforderung des Fahrerassistenzsystems niedriger eingestellt wird.

6. Vorrichtung zur Deaktivierung eines Fahrerassistenzsystems zur autonomen Querführung eines Fahrzeuges gemäß einem der vorangegangenen Ansprüche 1 bis 5.

7. Vorrichtung nach Anspruch 6, wobei der Drucksensor (1) aus einem Material besteht, welches unter Einwirkung von Druck ein elektrisches Signal abgibt.

8. Vorrichtung nach Anspruch 7, wobei das Material des Drucksensors (1) ein magnetorheologisches, ein elektrorheologisches, ein dielektrisches oder ein piezoelektrisches Material ist.

9. Vorrichtung nach Anspruch 7 oder 8, wobei der Drucksensor (1) eine Folie ist oder eine Vielzahl von Sensoren in eine Folie integriert sind.

## Claims

1. A method for deactivating a driver assistance system for autonomous transverse guidance of a vehicle, comprising a sensor unit for detecting contact with the rim (2) of a steering wheel by the driver, and a control unit which, by means of the detected contact, identifies a request by the driver to transfer from the autonomous transverse guidance into a manual transverse guidance by the driver,
**characterised in that**
the sensor unit constitutes at least one pressure sensor (1), which extends at least over a portion of the surface of the steering wheel rim (2) usually touched by the hands of the driver, but which does not comprise the area (3) of the surface of the steering wheel rim (2) which, viewed in a cross-section of the steering wheel rim (2), describes an approximately circular-segment-shaped arc extending over a sector angle (β) in the region of 90°, which arc is spaced apart as far as possible from the centre point (P) of the steering wheel.

2. A method according to claim 1, wherein the control unit deactivates the autonomous transverse guidance only when a contact pressure detected by the pressure sensor (1) exceeds a limit value.

3. A method according to claim 2, wherein the limit value is adjustable depending on a driving situation.

4. A method according to claim 3, wherein the limit value is adjusted increasingly with increasing vehicle speed.

5. A method according to one of the preceding claims, wherein the limit value is adjusted decreasingly in the event of a control transfer request by the driver assistance system.

6. A device for deactivating a driver assistance system for autonomous transverse guidance of a vehicle according to one of preceding claims 1 to 5.

7. A device according to claim 6, wherein the pressure sensor (1) is made of a material which emits an electrical signal under action of pressure.

8. A device according to claim 7, wherein the material of the pressure sensor (1) is a magnetorheological, an electrorheological, a dielectric or a piezoelectric material.

9. A device according to claim 7 or 8, wherein the pressure sensor (1) is a film, or a plurality of sensors is integrated into a film.

## Revendications

1. Procédé de désactivation d'un système d'assistance à la conduite permettant un guidage transversal autonome d'un véhicule qui comporte une unité de capteur permettant de détecter un contact avec la couronne (2) du volant de direction par le conducteur, ainsi qu'une unité de commande qui identifie du fait du contact détecté un souhait du conducteur de passage du guidage transversal autonome à un guidage transversal manuel par celui-ci,
**caractérisé en ce que**
l'unité de capteur est constituée par au moins un capteur de pression (1) qui s'étend sur au moins une partie de la surface de la couronne (2) du volant, avec laquelle le conducteur vient habituellement en contact avec ses mains, mais ne comprenant toutefois pas la zone (3) de la surface de la couronne du volant (2) qui considérée dans une section de la couronne (2) du volant décrit un arc essentiellement en forme de segment circulaire s'étendant sur un secteur angulaire (β) de l'ordre de 90°, qui est situé à la plus grande distance possible du centre (P) du volant.

2. Procédé conforme à la revendication 1,
selon lequel l'unité de commande ne désactive le guidage transversal autonome qui lors du dépassement d'une valeur limite de la pression de contact détectée par le capteur de pression (1).

3. Procédé conforme à la revendication 2,
selon lequel la valeur limite peut être réglée en fonction de la situation de conduite.

4. Procédé conforme à la revendication 3,
selon lequel la valeur limite est réglée à une valeur plus élevée lorsque la vitesse augmente.

5. Procédé conforme à l'une des revendications précédentes,
selon lequel la valeur limite est réglée à une valeur plus faible lorsque survient une demande de reprise du système d'assistance à la conduite.

6. Dispositif de désactivation d'un système assistance à la conduite permettant un guidage autonome d'un véhicule conformément à l'une des revendications précédentes 1 à 5.

7. Dispositif conforme à la revendication 6,
dans lequel le capteur de pression (1) est réalisé en un matériau qui délivre un signal électrique sous l'action d'une pression.

8. Dispositif conforme à la revendication 7,
dans lequel le matériau du capteur de pression (1) est un matériau magnétorhéologique, un matériau électrorhéologique, un matériau diélectrique ou un matériau piézoélectrique.

9. Dispositif conforme à la revendication 7 ou 8,
dans lequel le capteur de pression (1) est un film ou un ensemble de capteurs est intégré dans un film.
